# EUROPEAN PATENT APPLICATION

(11) **EP 3 309 775 A1**
(43) Date of publication of application: **18.04.2018**
(21) Application number: 15891402.8
(22) Date of filing: 30.11.2015
(51) Int. Cl.: G09G 3/36

(54) **SHIFT REGISTER UNIT, GATE DRIVE CIRCUIT AND DISPLAY DEVICE**

(30) Priority: 15.06.2015 CN 201510332638
(71) Applicant: BOE Technology Group Co., Ltd., Beijing 100015 (CN); Hefei BOE Optoelectronics Technology Co., Ltd., Hefei, Anhui 230012 (CN)
(72) Inventor: ZHANG, Xiaojie, Beijing 100176 (CN); SHAO, Xianjie, Beijing 100176 (CN)
(74) Representative: Klunker IP Patentanwälte PartG mbB
(86) International application number: PCT/CN2015/095991
(87) International publication number: WO 2016/201909

(57) **Abstract**

A shift register unit, comprises: a first output module (10) and a second output module (20), configured to output a signal of a clock signal terminal (CLK) to a signal output terminal (OUT) under the control of a pull-up control node (PU); an input module (30), configured to output a voltage of the first power supply terminal (VDD) to the pull-up control node (PU) under the control of a signal of the signal input terminal (IN); a pull-down control module (40), configured to pull down a signal of the pull-down control node (PD) to a voltage of the second power supply terminal (VSS) under the control of the signal input terminal (IN); a pull-down module (50), configured to pull down signals of the pull-up control node (PU) and the signal output terminal (OUT) to the voltage of the second power supply (VSS) under the control of the pull-down control node (PD); and a reset module (60), configured to output a signal of the first power supply terminal (VDD) to the pull-down control node (PD) under the control of the reset signal terminal (RESET). The shift register unit is capable of raising the output capability of the signal output terminal (OUT) and shortening the falling time of the output waveform. A gate driving circuit and a display apparatus are also provided.

## Description

### TECHNICAL FIELD

The present disclosure relates to a shift register unit, a gate driving circuit and a display apparatus.

### BACKGROUND

A liquid crystal display (LCD) has been applied widely in products and components having the display function including a mobile phone, a tablet computer, a television set, a display, a notebook computer, a camera, a digital photo frame, a navigator and so on due to its advantages of low power consumption, light weight, thin thickness, no electromagnetic radiation and pollution free and so on.

In the existing liquid crystal display, a gate driving circuit adopts usually a gate driver on array (GOA) design of integrating a thin film transistor (TFT) gate switching circuit on an array substrate of a display panel to form a scanning drive of the display panel, and provides a scan signal to a gate scan line of a pixel array by using a gate line driving circuit, so as to realize scanning the pixel array progressively.

However, as resolution of the liquid crystal display becomes higher increasingly, signal writing time of a data driving circuit becomes shorter and shorter. The use of the existing gate driving circuit would make the falling time of the output waveform of the gate driving circuit relatively long, which results in insufficient writing of the pixel voltage, and thus affects displaying picture and displaying quality of the liquid crystal display.

### SUMMARY

There are provided in embodiments of the present disclosure a shift register unit, a gate driving circuit and a display apparatus, which are capable of raising output capability of a signal output terminal and shortening a falling time of an output waveform of a signal output terminal.

There is provided in an embodiment of the present disclosure a shift register unit, comprising:
a first output module, connected to a pull-up control node, a clock signal terminal and a second output module respectively and configured to output a signal of the clock signal terminal to a second output module under a control of the pull-up control node;
the second output module, connected to a signal output terminal, the clock signal terminal and the first output module respectively and configured to output the signal of the clock signal terminal to the signal output terminal under a control of the first output module;
an input module, connected to the pull-up control node, a first power supply terminal, and a signal input terminal respectively and configured to output a voltage of the first power supply terminal to the pull-up control node under a control of a signal of the signal input terminal;
a pull-down control module, connected to the signal input terminal, a pull-down control node and a second power supply terminal respectively and configured to pull down a signal of the pull-down control node to a voltage of the second power supply terminal under the control of the signal of the signal input terminal;
a pull-down module, connected to the pull-down control node, the pull-up control node, the signal output terminal and the second power supply terminal respectively and configured to pull down signals of the pull-up control node and the signal output terminal to the voltage of the second power supply under a control of the pull-down control node; and
a reset module, connected to the first power supply terminal, a reset signal terminal and the pull-down control node respectively and configured to output a signal of the first power supply terminal to the pull-down control node under a control of the reset signal terminal.

There is provided in another embodiment of the present disclosure a gate driving circuit, comprising two stages of the shift register unit as described above.
except a first stage of shift register unit, a signal output terminal of a next stage of shift register unit is connected to a reset signal terminal of a previous stage of shift register unit;
except a last stage of shift register unit, a signal output terminal of a previous stage of shift register unit is connected to a signal input terminal of a next stage of shift register unit;
a signal input terminal of the first stage of shift register unit is inputted a frame start signal;
a reset signal terminal of a last stage of shift register unit is inputted a reset signal.

There is provided in another embodiment of the present disclosure a display apparatus, comprising the gate driving circuit as described above.

There is provided in another embodiment of the present disclosure a driving method for driving the shift register unit as described above, comprising:
in a first phase, a clock signal terminal and a reset signal terminal are inputted a low level, and a signal input terminal is inputted a high level;
under the control of the signal of the signal input terminal, the input module is used to output a voltage of the first voltage terminal to the pull-up control node to pull up a potential of the pull-up control node; under the control of the signal of the signal input terminal, the pull-down control module is used to pull down the signal of the pull-down control node to the voltage of the second power supply terminal;
in a second phase, the clock signal terminal is inputted a high level, and the signal input terminal and the reset signal terminal are inputted a low level;
under the control of the pull-up control node, the first output module is used to output the signal of the clock signal terminal to the second output module; under the control of the first output module, the second output module is used to output the signal of the clock signal terminal to the signal output terminal;
in a third phase, the clock signal terminal and the signal input terminal are inputted a low level, and the reset signal terminal is inputted a high level;
under the control of the signal of the reset signal terminal, the reset module is used to output a signal of a first power supply terminal to the pull-down control node to pull up the pull-down control node; under the control of the pull-down control node, the pull-down module is used to pull down the signal of the pull-up control node and the signal of the signal output terminal to the voltage of the second power supply terminal, so as to realize resetting.

Thus it can be seen that there are provided in the embodiments of the present disclosure a shift register unit, a gate driving circuit and a display apparatus. The shift register unit comprises: the first output module, connected to the pull-up control node, the clock signal terminal and the second output module respectively and configured to output the signal of the clock signal terminal to the second output module under the control of the pull-up control node; the second output module, connected to the signal output terminal, the clock signal terminal and the first output module respectively and configured to output the signal of the clock signal terminal to the signal output terminal under the control of the first output module; the input module, connected to the pull-up control node, the first power supply terminal, the signal input terminal respectively and configured to output the voltage of the first power supply terminal to the pull-up control node under the control of the signal of the signal input terminal; the pull-down control module, connected to the signal input terminal, the pull-down control node and the second power supply terminal respectively and configured to pull down the signal of the pull-down control node to the voltage of the second power supply terminal under the control of the signal of the signal input terminal; a pull-down module, connected to the pull-down control node, the pull-up control node, the signal output terminal and the second power supply terminal respectively and configured to pull down the signals of the pull-up control node and the signal output terminal to the voltage of the second power supply terminal under the control of the pull-down control node; and a reset module, connected to the first power supply terminal, the reset signal terminal, and the pull-down control node and configured to output the signal of the first power supply terminal to the pull-down control node under the control of the reset signal terminal.

In this way, in the charging phase, the pull-down control module can pull down the potential of the pull-down control node under the control of the signal of the signal input terminal, to ensure the normal output of the signal output terminal; in the outputting phase, the first output module outputs the signal of the clock signal output terminal to the signal output terminal under the control of the pull-up control node, and the second output module outputs the signal of the clock signal output terminal to the signal output terminal under the control of the first output module, so as to be capable of outputting the signal of the clock signal output terminal to the signal output terminal and inputting a scan signal of the signal output terminal to a corresponding gate line and be capable of raising the output capability of the shift register unit. In the resetting phase, the reset module can pull up the potential of the pull-down control node and pull down the potential of the pull-up control node and the potential of the signal output terminal through the pull-down module, to raise efficiency of resetting. To sum up, by adding an output module, it is capable of raising the output capability of the shift register unit in the outputting phase greatly and shortening the falling time of the output waveform in the resetting phase, so as to enhance the output characteristic of the gate driving circuit and prevent the picture display abnormality caused by reduction of the output characteristics.

### BRIEF DESCRIPTION OF THE DRAWINGS

Fig.1 is a schematic diagram of a structure of a shift register unit provided in an embodiment of the present disclosure;
Fig.2 is a schematic diagram of a structure of a gate driving circuit composed of a plurality of shift register units connected in cascades as shown in Fig.1 provided in an embodiment of the-present disclosure;
Fig.3 is a schematic diagram of a specific structure based on the shift register unit as shown in Fig.1 provided in an embodiment of the present disclosure; and
Fig.4 is a control signal timing diagram of the shift register unit as shown in Fig.3 in an embodiment of the present disclosure.

### DETAILED DESCRIPTION

Technical solutions in embodiments of the present disclosure will be described clearly and completely by combining with figures in the embodiments of the present disclosure. Obviously, the embodiments described below are just a part of embodiments of the present disclosure but not all of the embodiments. Based on the embodiments of the present disclosure, all of other embodiments obtained by those ordinary skilled in the art without paying any inventive labor belong to the scope sought for protection in the present disclosure.

In the description of the present disclosure, it needs to understand that orientation or position relationships indicated by terms of "center", "up", "down", "forward', "backward", "left", "right", "vertical", "horizontal", "top", "bottom", "inside" and "outside" or the like are orientation or position relationships as shown in the figures, and are just used to facilitate description of the present disclosure and simplify the description, instead of indicating or suggesting that the referred apparatus or element must have a specific orientation and be constructed and operated in a specific direction, and thus cannot be understood as a limitation to the present disclosure. In the description of the present disclosure, unless otherwise specified, the meaning of "a plurality of" means two or more than two.

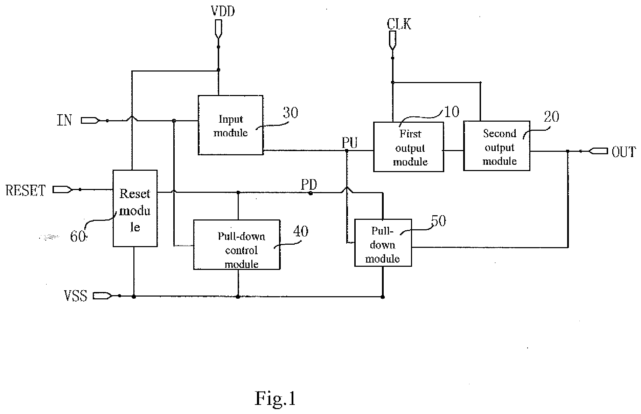

Fig.1 shows a schematic diagram of a structure of a shift register unit provided in an embodiment of the present disclosure. As shown in Fig.1, the shift register unit can comprise:
a first output module 10, connected to a pull-up control node PU, a clock signal terminal CLK and a second output module 20 respectively, and configured to output a signal of the clock signal terminal CLK to the second output module 20 under control of the pull-up control node PU;
a second output module 20, connected to a signal output terminal OUT, the clock signal terminal CLK and the first output module 10 respectively, and configured to output the signal of the clock signal terminal CLK to the signal output terminal OUT under control of the first output module 10;
an input module 30, connected to the pull-up control node PU, a first power supply terminal VDD, a signal input terminal IN respectively, and configured to output a voltage of the first power supply terminal VDD to the pull-up control node PU under control of a signal of the signal input terminal IN;
a pull-down control module 40, connected to the signal input terminal IN, a pull-down control node PD and a second power supply terminal VSS respectively, and configured to pull down a signal of the pull-down control node PD to a voltage of the second power supply terminal VSS under the control of the signal of the signal input terminal IN;
a pull-down module 50, connected to the pull-down control node PD, the pull-up control node PU, the signal output terminal OUT and the second power supply terminal VSS respectively, and configured to pull down signals of the pull-up control node PU and the signal output terminal OUT to the voltage of the second power supply terminal VSS under control of the pull-down control node PD; and
a reset module 60, connected to the first power supply terminal VDD, a reset signal terminal RESET and the pull-down control node PD respectively, and configured to output the signal of the first power supply terminal VDD to the pull-down control node PD under control of the reset signal terminal RESET.

By adding an output module, the shift register unit is capable of raising the output capability of the shift register unit greatly in the outputting phase and shortening the falling time of the output waveform in the resetting phase, so as to raise the output characteristic of the gate driving circuit and prevent the picture display abnormality caused by reduction of the output characteristics.

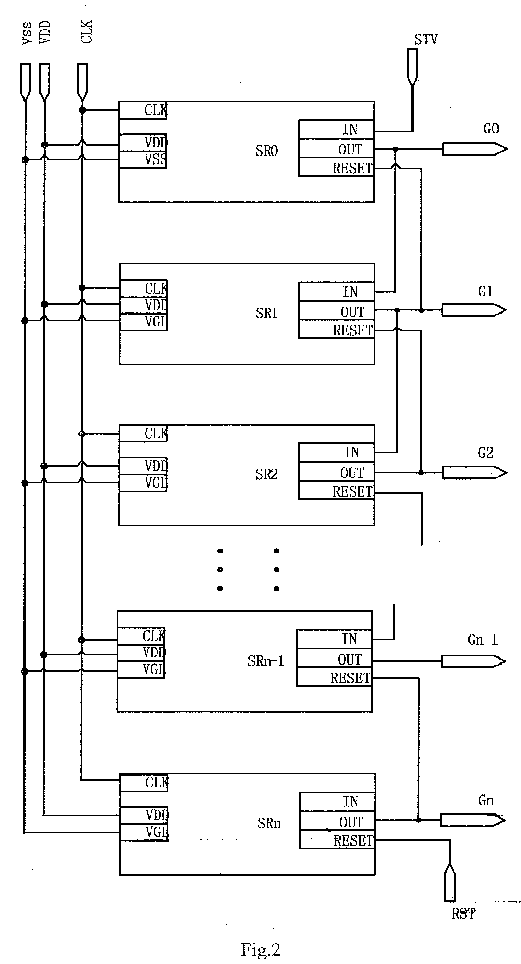

Fig.2 shows a schematic diagram of a structure of a gate driving circuit composed of a plurality of shift register units connected in cascades as shown in Fig.1 provided in an embodiment of the present disclosure.

Exemplarily, as shown in Fig.2, at least two stages of shift register units (SR0, SRI ... SRn) as described above are capable of constituting a gate driving circuit. Each stage of shift register unit inputs a scan signal (G0, G1 ... Gn) to each row of gate line progressively.

Herein, a signal input terminal IN of a first stage of shift register unit SR0 receives a start signal inputted by a start signal terminal STV.

Except for the first stage of shift register unit SR0, a signal input terminal IN of each of remaining shift register units is connected to a signal output terminal OUT of an adjacent previous stage of shift register unit.

Except for a last stage of shift register unit SRn, a reset signal terminal RESET of each of remaining shift register units is connected to the signal output terminal OUT of an adjacent next stage of shift register unit.

The reset signal terminal RESET of a last stage of shift register unit SRn can be inputted a reset signal inputted by a reset signal terminal RST.

The above gate driving circuit has beneficial effects the same as the shift register unit in the previous embodiment. The structure and beneficial effects of the shift register unit have been described, and thus no further description is given herein.

In addition, the embodiment of the present disclosure is described by taking the first voltage terminal VDD being inputted a high level and the second voltage terminal VSS being inputted a low level as an example.

There are provided a shift register unit, a gate driving circuit and a display apparatus in embodiments of the present disclosure. The shift register unit comprises: a first output module 10, connected to a pull-up control node PU, a clock signal terminal CLK and a second output module respectively and configured to output a signal of the clock signal terminal CLK to the second output module 20 under the control of the pull-up control node PU; a second output module 20, connected to a signal output terminal OUT, the clock signal terminal CLK and the first output terminal 10 respectively and configured to output the signal of the clock signal terminal CLK to the signal output terminal OUT under the control of the first output module 10; an input module 30, connected to the pull-up control node PU, a first power supply terminal VDD, a signal input terminal IN respectively and configured to output a voltage of the first power supply terminal VDD to the pull-up control node PU under the control of a signal of the signal input terminal IN; a pull-down control module 40, connected to the signal input terminal IN, the pull-down control node PD and the second power supply terminal VSS respectively and configured to pull down a signal of the pull-down control node PD to a voltage of the second power supply terminal VSS under the control of the signal of the signal input terminal IN; a pull-down module 50, connected to the pull-down control node PD, the pull-up control node PU, the signal output terminal OUT and the second power supply terminal VSS respectively and configured to pull down signals of the pull-up control node PU and the signal output terminal OUT to the voltage of the second power supply terminal VSS under the control of the pull-down control node PD; and a reset module 60, connected to the first power supply terminal VDD, a reset signal terminal RESET and the pull-down control node PD respectively and configured to output the signal of the first power supply terminal VDD to the pull-down control node PD under the control of the reset signal terminal RESET.

In this way, in the charging phase, under the control of the signal of the signal input terminal IN, the input module 30 outputs the voltage of the first power supply terminal VDD to the pull-up control node PU, raises the pull-up control node PU to a high level, and charge the first capacitor C1. At the same time, the pull-down control module 40 can perform noise reduction process on the pull-down control node PD under the control of the signal of the signal input terminal IN, to provide a condition for charging the first capacitor C1 normally. In the outputting phase, the first output module 10 outputs the signal of the clock signal output terminal CLK to the signal output terminal OUT under the control of the pull-up control node PU, and the second output module 20 outputs the signal of the clock signal output terminal CLK to the signal output terminal OUT under the control of the first output module 10, so as to be capable of outputting the signal of the clock signal output terminal CLK to the signal output terminal OUT and inputting a scan signal of the signal output terminal OUT to a corresponding gate line; and be capable of raising the output capability of the shift register unit. At the same time, the pull-down control module 40 can pull down the potential of the pull-down control node PD under the control of the signal of the signal input terminal IN, to ensure normal output of the signal output terminal OUT. In the resetting phase, the reset module 60 can pull up the potential of the pull-down control node PD and pull down the potential of the pull-up control node PU and the potential of the signal output terminal OUT through the pull-down module 50, to raise efficiency of resetting. To sum up, by adding an output module, it is capable of raising the output capability of the shift register unit in the outputting phase greatly and shortening the falling time of the output waveform in the resetting phase, so as to raise the output characteristic of the gate driving circuit and prevent the picture display abnormality caused by reduction of the output characteristics.

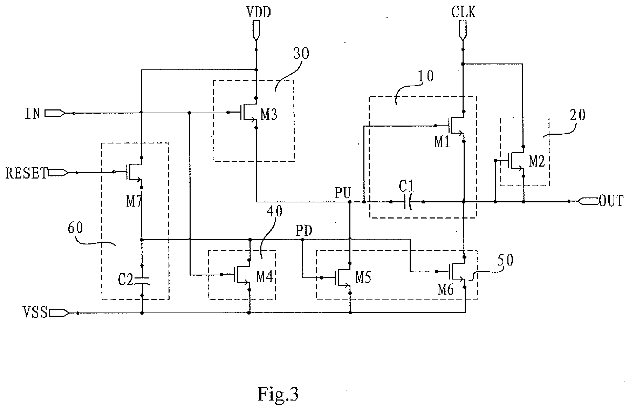

Fig.3 shows a schematic diagram of a specific structure based on the shift register unit as shown in Fig.1 provided in an embodiment of the present disclosure.

The specific structure of the shift register unit as shown in Fig.3 will be illustrated in detail.

As shown in Fig.3, the first output module 10 can comprise:
a first transistor M1, whose gate is connected to the pull-up control node PU, first electrode is connected to the clock signal terminal CLK, and second electrode is connected to the second output module 20;
a first capacitor C1, whose one terminal is connected to the pull-up control node PU and another terminal is connected to the second output module 20.

For example, in the outputting phase, the pull-up control node PU is at a high level, the signal of the clock signal terminal CLK is at the high level, and the first transistor M1 can be turned on, so that the high level signal inputted by the clock signal terminal CLK is outputted to the second output module 20 through the first transistor M1, and is used to control the second output module 20 to output the high level signal.

As shown in Fig.3, the second output module 20 can comprise:
a second transistor M2, whose gate is connected to the first output module 10, first electrode is connected to the clock signal terminal CLK, and second electrode is connected to the signal output terminal OUT. In the embodiment of the present disclosure, the gate of the second transistor M2 is connected to the second electrode of the first transistor.

For example, in the outputting phase, under the control of the first output module 10, the second transistor M2 can be turned on, so that the high level signal inputted by the clock signal terminal CLK is outputted to the signal output terminal OUT through the second transistor M2, so as to be taken as the scan signals (G0, G1...Gn) to scan gate lines corresponding to the shift register units (SR0, SR1... SRn).

Under the joint effect of the first output module 10 and the second output module 20, the output capability of the signal output terminal of the shift register unit is raised, so that the output characteristic of the entire gate output circuit is enhanced.

As shown in Fig.3, the input module 30 can comprise:
a third transistor M3, whose gate is connected to the signal input terminal IN, first electrode is connected to the first power supply terminal VDD, and second electrode is connected to the pull-up control node PU.

For example, in the charging phase, under the control of the high level signal of the signal input terminal IN, the third transistor M3 can be turned on, so that the pull-up control node PU is raised to the high level and the first capacitor C1 is charged through the pull-up control node PU, so as to prepare for the shift register unit to output the scan signal.

As shown in Fig.3, the pull-down control module 40 comprises:
a fourth transistor M4, whose gate is connected to the signal input terminal IN, first electrode is connected to the pull-down control node PD, and second electrode is connected to the second power supply terminal VSS.

For example, in the charging phase, under the control of the high level signal of the signal input terminal IN, the gate of the fourth transistor M4 can be turned on to perform noise reduction process on the pull-down control node PD constantly, so as to avoid from turning on the first output module 10 and the second output module 20 by mistake, and outputting the signal output terminal OUT of the shift register unit by mistake, due to rising of the potential of the pull-down control node PD.

As shown in Fig.3, the pull-down module 50 comprises:
a fifth transistor M5, whose gate is connected to the pull-down control node PD, first electrode is connected to the pull-up control node PU, and second electrode is connected to the second power supply terminal VSS;
a sixth transistor M6, whose gate is connected to the pull-down control node PD, first electrode is connected to the signal output terminal OUT, and second electrode is connected to the second power supply terminal VSS.

For example, in the charging phase, under the control of a low level signal of the pull-down control node PD, the fourth transistor M4, the fifth transistor M5 and the sixth transistor M6 are turned off, and are capable of charging the first capacitor C1 constantly; in the outputting phase, under the control of the low level signal of the pull-down control node PD, the fourth transistor M4, the fifth transistor M5 and the sixth transistor M6 are in a turn-off state, which ensures normal output of the signal output terminal OUT.

As shown in Fig.3, the reset module 60 can comprise:
a seventh transistor M7, whose gate is connected to the reset signal terminal RESET, first electrode is connected to the first power supply terminal VDD, and second electrode is connected to the pull-down control node PD.

For example, in the resetting phase, under the control of a high level signal of the reset signal terminal RESET, the seventh transistor M7 is turned on, so that the pull-down control node PD rises to the high level. Now, the fifth transistor M5 and the sixth transistor M6 are turned on, and the fifth transistor M5 and the sixth transistor M6 pull down the signals of the pull-up control node PU and the signal output terminal OUT, to reduce the voltages of the pull-up control node PU and the signal output terminal OUT to the low level, which is capable of shortening the falling time of the output waveform and raising the efficiency of resetting.

It needs to note that all of the transistors in the embodiments of the present disclosure are described by N-type transistors as an example. Herein, a first electrode of a transistor can be a source, and a second electrode thereof is a drain; or the first electrode of the transistor can be the drain, and the second electrode thereof can be the source, to which the present disclosure does not limit.

Alternatively, the reset module 60 is connected to the second power supply terminal VSS, and the reset module 60 can further comprise:
a second capacitor C2, whose one terminal is connected to the pull-down control node PD and another terminal is connected to the second power supply terminal VSS.

Exemplarily, by setting the second capacitor C2, in the charging phase, it is capable of preventing shifting of a threshold voltage of the second capacitor per se and insufficient charging of the first capacitor C1 caused by charging the second capacitor C2 constantly because the fifth transistor M5 and the sixth transistor M6 are turned off; in the resetting phase, under the control of the high level signal of the reset signal terminal RESET, the seventh transistor M7 is turned on to charge the second capacitor C2. Before a signal of a next frame reaches, as the signal of the clock signal terminal CLK changes periodically, due to existence of the second capacitor C2, the pull-down control node PD always maintains at a high potential to perform noise reduction process on the pull-up control node PU and the signal output terminal OUT constantly, so as to ensure accuracy and stability of the output of the signal output terminal OUT.

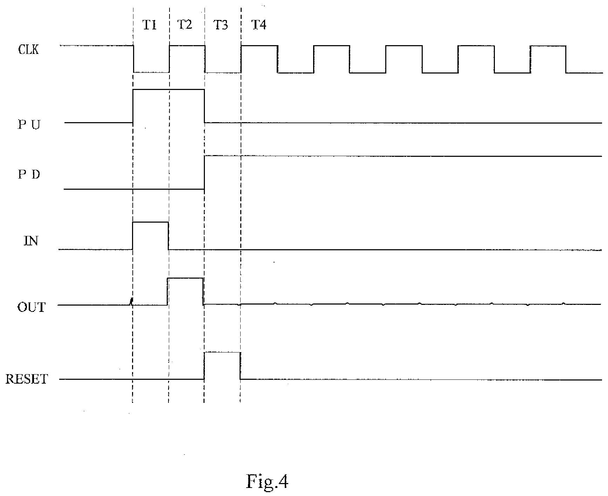

Fig.4 shows a control signal timing diagram of the shift register unit as shown in Fig.3 in an embodiment of the present disclosure.

An operation process of the shift register unit as shown in Fig.3 will be described in detail by combining with the timing diagram of the shift register unit as shown in Fig.4.

In a first phase T1, CLK=0; PU=1; PD=0; IN=1; RESET=0. It needs to note that in the following embodiment, "0" represents a low level, and "1" represents a high level.

The signal of the input signal terminal IN is at the high level, the third transistor M3 is turned on to raise the pull-up control node PU to the high level and charge the first capacitor C1 through the pull-up control node PU.

At the same time, the signal of the input signal terminal IN is at the high level, the signal of the reset signal terminal RESET is at the low level, the gate of the fourth transistor M4 is turned on to perform noise reduction process on the pull-down control node PD constantly, so that the second capacitor C2 is in a discharging state and the fifth transistor M5 and the sixth transistor M6 are in a turn-off state, and the pull-down control node PD is at the low level, which prevents efficiently insufficient charging of the first capacitor C1 caused by that the fifth transistor M5 and the sixth transistor M6 charge the second capacitor C2 constantly due to the shifting of the threshold voltage of the M5 and M6 per se.

In this phase, the pull-up control node PU rises to the high level. At this time, the gate of the first transistor M1 is turned on; however, since the signal of the clock signal terminal CLK is at the low level, the first transistor M1 is not turned on, the second transistor M2 is also in the turn-off state, and the signal output terminal OUT outputs the low level.

In the second phase T2, CLK=1; PU=1; PD=0; IN=0; RESET=0.

The signal of the clock signal terminal CLK is at the high level, the signal of the signal input terminal IN is at the low level, and the first transistor M1 is in the turn-off state. Since the pull-up control node PU is at the high level, the first transistor M1 is turned on, and the second transistor M2 is turned on, and the signal output terminal OUT outputs the high level. At this time, since the first transistor M1 and the second transistor M2 output simultaneously, the output capability of the signal output terminal is enhanced.

In this phase, since the signal of the signal input terminal IN is at the low level, the signal of the reset signal terminal RESET is at the low level, the fourth transistor M4, the fifth transistor M5 and the sixth transistor M6 are in the turn-off state, and the node PD is maintained at the low level, so that the normal output of the signal output terminal is ensured.

In a third phase T3, CLK=0; PU=0; PD=1; IN=0; RESET=1.

The signal of the reset signal terminal RESET is at the high level, and thus the seventh transistor M7 is turned on to charge the second capacitor C2, so that the pull-down control node PD rises to the high level. At this time, the fifth transistor M5 and the sixth transistor M6 are turned on, and at the same time discharge the first capacitor C1, so that the signals of the pull-up control node PU and the signal output terminal OUT reduce to the low level quickly, thereby realizing the resetting function.

In this phase, during a short time when the CLK signal converts from the high level into the low level, the voltage of the signal output terminal OUT is still at the high level although there is reduction, the gate and source of the second transistor M2 are still at the high level, and the drain thereof is at the low level, and thus the second transistor M2 is still in the turn-on state, but only that the source and the drain converts with each other to pull down the voltage of the signal output terminal OUT from the high level to the low level quickly. As such, the falling time of the output waveform is shortened, and thus the efficiency of the resetting function is raised greatly.

Before the signal of the next frame reaches, as the signal of the clock signal terminal CLK changes periodically, due to the existence of the second capacitor C2, the pull-down control node PD always maintains at the high level to perform noise reduction process on the pull-up control node PU and the signal output terminal OUT, so as to ensure accuracy and stability of the output of the signal output terminal OUT.

The phases T1-T3 can be referred to as the operation time of the shift register unit. The signal output terminal OUT outputs the high level only in the second phase T2, and thus the second phase T2 can be the data outputting phase of the shift register unit. Phases T1 and T3 are non-outputting phases of the shift register unit. In these phases, the signal output terminal OUT outputs the low level.

Exemplarily, a driving method for driving a shift register unit according to an embodiment of the present disclosure comprises following operation processes:

In a first phase, the clock signal terminal and the reset signal terminal are inputted the low level, and the signal input terminal is inputted the high level; under the control of the signal of the signal input terminal, the input module is used to output the voltage of the first voltage terminal to the pull-up control node to pull up the potential of the pull-up control node; under the control of the signal of the signal input terminal, the pull-down control module is used to pull down the signal of the pull-down control node to the voltage of the second power supply terminal;

In a second phase, the clock signal terminal is inputted the high level, and the signal input terminal and the reset signal terminal are inputted the low level; under the control of the pull-up control node, the first output module is used to output the signal of the clock signal terminal to the second output module; and under the control of the first output module, the second output module is used to output the signal of the clock signal terminal to the signal output terminal;

In a third phase, the clock signal terminal and the signal input terminal are inputted the low level, and the reset signal terminal is inputted the high level; under the control of the signal of the reset signal terminal, the reset module is used to output the signal of the first power supply terminal to the pull-down control node to pull up the pull-down control node; under the control of the pull-down control node, the pull-down module is used to pull down the signal of the pull-up control node and the signal of the signal output terminal to the voltage of the second power supply terminal, so as to realize resetting.

In addition, all of the transistors (M1-M7) described above can be P-type transistors. When the transistors in the shift register unit and the transistors in the pixel unit connected to the gate line are all P-type transistors, it needs to correspondingly adjust the timing of the drive signal and the input signal of the circuit.

There is provided in an embodiment of the present disclosure a display device, comprising any one of gate driving circuits as described above. This gate driving circuit has beneficial effects the same as the gate driving circuit provided in the previous embodiment of the present disclosure. Since the gate driving circuit has been described in detail in the previous embodiment, no further details are given herein.

This display device can be in particular any liquid crystal display product or component having the display function such as a liquid crystal display, a liquid crystal television, a digital photo frame, a mobile phone, and a tablet computer and so on.

There is provided in an embodiment of the present disclosure a driving method for driving any one of the shift register unit described above, comprising:

In a first phase T1, CLK=0; PU=1; PD=0; IN=1; RESET=0.

The input module 30 can output the voltage of the first voltage terminal to the pull-up control node PU under the control of the signal of the signal input terminal IN to pull up the potential of the pull-up control node PU; the pull-down control module 40 can pull down the signal of the pull-down control node PD to the voltage of the second power supply terminal VSS under the control of the signal of the signal input terminal IN, so as to realize charging the pull-up control node PU constantly and prepare for the shift register unit to output the scan signal.

In the second phase T2, CLK=1; PU=1; PD=0; IN=0; RESET=0.

Under the control of the pull-up control node PU, the first output module 10 can output the clock signal CLK inputted by the clock signal terminal CLK to the second output module 20. The second output module 20 can output the clock signal CLK inputted by the clock signal terminal CLK to the signal output terminal OUT under the control of the first output module 10, so that the signal output terminal OUT inputs the scan signal to the gate line connected to the shift register unit.

In this phase, by adding one output module, it is capable of raising the output capability of the shift register unit.

In the third phase T3, CLK=0; PU=0; PD=1; IN=0; RESET=1.

The reset module 60 can output the signal of the first power supply terminal VDD to the pull-down control node PD under the control of the signal of the reset signal terminal RESET to pull up the pull-down control node PD. The pull-down module 50 pulls down the signal of the pull-up control node PU and the signal of the signal output terminal OUT to the voltage of the second power supply terminal VSS under the control of the pull-down control node PD, so as to realize resetting.

In this phase, during a short time when the clock signal inputted by the clock signal terminal CLK converts from the high level into the low level, despite reduction of the voltage of the signal output terminal OUT, it is still at the high level, the second transistor M2 in the second output module 20 is still in the turn-on state. As such, the voltage of the signal output terminal OUT is pulled down from the high level to the low level rapidly, the falling time of the output waveform is shortened, and the efficiency of the resetting function is raised greatly.

Those ordinary skilled in the art can understand that all or part of steps for implementing the above method embodiments can be completed by program instruction-related hardware. The above program can be stored in a computer readable storage medium. When this program is executed, the steps comprising the above method embodiments are performed; the above storage medium comprises various medium that can store the program codes such as ROM, RAM, a magnetic disk or an optical disk or the like.

The above descriptions are just specific implementations of the present disclosure. However, the protection scope of the present disclosure is not limited thereto. Any alternation or replacement that can be easily conceived by those skilled in the art who are familiar with the present technical field within the technical scope of the present disclosure shall be included within the protection scope of the present disclosure. Therefore, the protection scope of the present disclosure shall be subjected to the protection scope of the Claims.

The present application claims the priority of a Chinese patent application No. 201510332638.X filed on June 15, 2015. Herein, the content disclosed by the Chinese patent application is incorporated in full by reference as a part of the present disclosure.

## Claims

1. A shift register unit, comprising:
a first output module, connected to a pull-up control node, a clock signal terminal and a second output module respectively, and configured to output a signal of the clock signal terminal to the second output module under the control of the pull-up control node;
the second output module, connected to a signal output terminal, the clock signal terminal and the first output module respectively, and configured to output the signal of the clock signal terminal to the signal output terminal under the control of the first output module;
an input module, connected to the pull-up control node, a first power supply terminal, and a signal input terminal respectively, and configured to output a voltage of the first power supply terminal to the pull-up control node under the control of a signal of the signal input terminal;
a pull-down control module, connected to the signal input terminal, a pull-down control node and a second power supply terminal respectively, and configured to pull down a signal of the pull-down control node to a voltage of the second power supply terminal under the control of the signal of the signal input terminal;
a pull-down module, connected to the pull-down control node, the pull-up control node, the signal output terminal and the second power supply terminal respectively, and configured to pull down signals of the pull-up control node and the signal output terminal to the voltage of the second power supply under the control of the pull-down control node; and
a reset module, connected to the first power supply terminal, a reset signal terminal and the pull-down control node respectively, and configured to output a signal of the first power supply terminal to the pull-down control node under the control of the reset signal terminal.

2. The shift register unit according to claim 1, wherein the first output module comprises:
a first transistor, whose gate is connected to the pull-up control node, first electrode is connected to the clock signal terminal, and second electrode is connected to the second output module; and
a first capacitor, whose one terminal is connected to the pull-up control node and another terminal is connected to the second output module.

3. The shift register unit according to claim 1, wherein the second output module comprises:
a second transistor, whose gate is connected to the first output module, first electrode is connected to the clock signal terminal, and second electrode is connected to the signal output terminal.

4. The shift register unit according to claim 1, wherein the input module comprises:
a third transistor, whose gate is connected to the signal input terminal, first electrode is connected to the first power supply terminal, and second electrode is connected to the pull-up control node.

5. The shift register unit according to claim 1, wherein the pull-down control module comprises:
a fourth transistor, whose gate is connected to the signal input terminal, first electrode is connected to the pull-down control node, and second electrode is connected to the second power supply terminal.

6. The shift register unit according to claim 1, wherein the pull-down module comprises:
a fifth transistor, whose gate is connected to the pull-down control node, first electrode is connected to the pull-up control node, and second electrode is connected to the second power supply terminal; and
a sixth transistor, whose gate is connected to the pull-down control node, first electrode is connected to the signal output terminal, and second electrode is connected to the second power supply terminal.

7. The shift register unit according to claim 1, wherein the reset module comprises:
a seventh transistor, whose gate is connected to the reset signal terminal, first electrode is connected to the first power supply terminal, and second electrode is connected to the pull-down control node.

8. The shift register unit according to claim 7, wherein the reset module is connected to the second power supply terminal, and further comprises:
a second capacitor, whose one terminal is connected to the pull-down control node, and another terminal is connected to the second power supply terminal.

9. A gate driving circuit, comprising at least two stages of the shift register units according to any one of claims 1 to 8;
except for a first stage of shift register unit, a signal output terminal of a next stage of shift register unit is connected to a reset signal terminal of a previous stage of shift register unit;
except for a last stage of shift register unit, a signal output terminal of a previous stage of shift register unit is connected to a signal input terminal of a next stage of shift register unit;
a signal input terminal of the first stage of shift register unit is inputted a frame start signal;
a reset signal terminal of a last stage of shift register unit is inputted a reset signal.

10. A display apparatus, comprising the gate driving circuit according to claim 9.

11. A driving method for driving a shift register unit, comprising:
in a first phase, inputting a low level to a clock signal terminal and a reset signal terminal are, and inputting a high level to a signal input terminal;
under the control of the signal of the signal input terminal, outputting by an input module a voltage of the first voltage terminal to the pull-up control node to pull up a potential of the pull-up control node; under the control of the signal of the signal input terminal, pulling down by a pull-down control module the signal of the pull-down control node to the voltage of the second power supply terminal;
in a second phase, inputting a high level to the clock signal terminal, and inputting a low level to the signal input terminal and the reset signal terminal;
under the control of the pull-up control node, outputting by a first output module the signal of the clock signal terminal to a second output module; under the control of the first output module, outputting by the second output module the signal of the clock signal terminal to the signal output terminal;
in a third phase, inputting a low level to the clock signal terminal and the signal input terminal, and inputting a high level to the reset signal terminal;
under the control of the signal of the reset signal terminal, outputting by a reset module a signal of a first power supply terminal to the pull-down control node to pull up the pull-down control node; under the control of the pull-down control node, pulling down by a pull-down module the signal of the pull-up control node and the signal of the signal output terminal to the voltage of the second power supply terminal to realize resetting.
